# EUROPEAN PATENT APPLICATION

(11) **EP 2 109 147 A1**
(43) Date of publication of application: **14.10.2009**
(21) Application number: 08103442.3
(22) Date of filing: 08.04.2008
(51) Int. Cl.: H01L 31/0224, H01L 31/052

(54) **Photovoltaic cell with surface plasmon resonance generating nano-structures**

(71) Applicant: FOM Institute for Atomic and Molueculair Physics, 1098 SJ Amsterdam (NL)
(72) Inventor: Catchpole, Kylie Rose, 1098 AR, Amsterdam (NL); Polman, Albert, 1019 AX, Amsterdam (NL)
(74) Representative: van Looijengoed, Ferry Antoin Theodorus

(57) **Abstract**

A photovoltaic cell is described comprising a semiconductor layer (1), preferably thin-film semiconducting layer, of a first conductivity type provided on a support substrate (2). A plasmon resonance generating metallic structure (3) is provided on the semiconductor layer for resonantly coupling light into the absorbing layer and transporting photo-induced charge carriers out of the absorbing layer, wherein the contact structure extends over a substantial part of the front side of the semiconductor layer and wherein the contact structure comprises a plurality of metallic finger (3) in contact with the semiconductor layer, the dimensions of the cross-section of each strip being smaller than 300 nm.

## Description

### Field of the invention

The invention relates to a photovoltaic cell with surface plasmon resonance generating nano-structures. More in particular, the invention relates to a photovoltaic cell with metal surface plasmon resonance generating nano-structures for coupling light into the cell and/or for transporting photo-induced charge carriers out of the cell. The invention further relates to a method of fabricating such structures.

### Background of the invention

Conventional screen-printed solar cell technology, which presently is the dominant technology in commercial silicon solar cell manufacturing, typically comprises a wafer-type semiconductor base with a heavily diffused emitter in order to provide good contact to a top contact structure for collecting the generated photocurrent. The top electrode comprises a metallic structure connected to external leads and to fingers, which are metallization areas extending over the surface area of the semiconductor for collecting photo-induced charge carriers out of the semiconductor. This conventional solar cell design however has a number of disadvantages.

One problem relates to the top surface screen-printed metallization, which requires a heavily doped emitter in order to achieve low contact resistance and adequate lateral conductivity in the semiconductor layer directly under the top surface. The doped emitter allows the fingers of the top contact to be sufficiently spaced apart in order to avoid excessive reflection caused by a high fraction of metal coverage of the top surface. A heavily doped emitter region however causes a significant degradation in the short wavelength response of the cell.

One way of reducing the problem of the doped emitter is described in WO2006/130910. This document describes an electrode structure for a solar cell comprising highly doped lines which run substantially perpendicular to the screen-printed fingers allowing the resistivity of the remaining parts of the top surface of the silicon to be in the order of 100 ohms per square as required for efficient photoconversion at short wavelengths. The highly doped lines, which are realized using a relatively expensive laser doping process step, still introduce degradation in the short wavelength response. Moreover, the screen printed metal finger generate relatively high reflectance losses. An alternative approach for improving the lateral conductivity of the emitter is the use of a transparent conducting oxide such as zinc oxide or indium tin oxide (ITO). Such conducting oxides however are expensive and have a tendency to degrade over long periods of time, particularly in the presence of moisture.

A further problem regarding conventional solar cells is cost reduction. Large scale and large area implementation requires further reduction of costs. One way of achieving this is reducing the thickness of silicon wafer. Alternatively, a thin-film silicon layer can be deposited on a support substrate. The efficiency of such thin-film cells however are presently rather poor when compared to conventional wafer-based silicon cells because of the relative poor light absorption. Conventional surface texture structures to improve the absorption cannot be used because of the reduced thickness of the silicon absorber.

In order to improve the absorption in a thin-film photovoltaic cell Pillai et al. ("Surface plasmon enhance silicon solar cells", Journal of Applied Physics, Vol. 101, 093105, 2007) propose the use of metal nanoparticles. These particles which are arranged on the light receiving area of the cell allow resonant excitation of surface plasmons thereby enhancing the absorption of light into a silicon solar cell. Such structures are also described in US patent application US2007/0289623. This document describes plasmon incoupling structures, including an Al/Cu nanoparticle plasmon resonant scattering layer, for efficient coupling of the light into thin-film photovoltaic cells.

A surface plasmon resonance is a collective oscillation of the conduction electrons in a metallic nanoparticle which is excited by incident light. The resonance frequency depends on particle size, shape and the local refractive index. The dimensions of the particles are such that they do not reflect the light but rather scatter it. When such structure is close to a semiconductor surface, light is preferentially scattered into the semiconductor rather than into the surrounding air, because of the high density of optical modes in the semiconductor.

Although the article by Pillai et al. reports improved spectral response of thin-film silicon on insulator (SOI) type of solar cell, the collection of the photo-induced current from a large area thin-film absorber remains a problem as highly doped emitter regions in such thin-film cells tend to have very poor electronic quality. Collection of the photo-generated current is also a particular problem for concentrator cells, which have to transport high currents through the emitter to the contacts.

### Summary of the invention

It is an object of the invention to reduce or eliminate at least one of the drawbacks in the prior art and to provide a photovoltaic cell, comprising a semiconductor layer, preferably a thin-film semiconductor layer provided on a support substrate, of a first conductivity type.

A surface plasmon resonance generating contact structure is provided on the semiconductor layer for resonantly coupling light into the thin-film semiconductor layer and transporting photo-induced charge carriers out of the semiconductor layer, wherein the contact structure comprises a plurality of metal fingers in electrical contact with the semiconductor layer, the dimensions of the cross-section of each finger being smaller than 300 nm.

The metallic contact structure according to the invention comprises a plurality of metal fingers with a cross-section of less than 300 nanometer, the short wavelength edge of the visible solar spectrum. Hence, the contact structure will not reflect light incident on the cell, but rather it allows the formation of surface plasmons resonances thereby efficiently coupling the light into the thin-film semiconductor layer, which may be semiconductor deposited on a substrate or a thin semiconductor wafer attached to a support substrate, and at the same time efficiently transporting photo-induced charge carriers out of the absorber without affecting the low wavelength response of the cell.

In one embodiment the dimensions of the cross-section of each finger are within a range between 100 and 200 nanometer. These dimensions ensure surface plasmon resonant scattering of visible light into the semiconductor layer. Below dimensions of 100nm the fingers tend to preferentially absorb rather than scatter light.

In a further embodiment the dielectric environment of the fingers is varied along its length by alternately contacting the finger locally with a high refractive index material and a low refractive index material. In one embodiment a predetermined number of areas of each finger is covered with a high refractive index material. The areas having an index of high refraction are almost completely transparent for wavelengths of interests (i.e. the solar spectrum) and the areas having an index of low refraction effectively form surface plasmon resonant scatters for wavelengths of the solar spectrum. Hence, the presence of areas having an index of high refraction thus avoids or reduces the problem of absorption of light that is polarized parallel to the axis of the finger.

In an embodiment each finger makes contact with the thin-film semiconductor through a number of contact windows in a low refractive index isolation layer provided over the thin-film semiconductor layer. In this configuration the areas of the metal finger in contact with the semiconductor layer form areas having an index of high refraction and the areas of the metallic finger in contact with the passivation layer form areas having an index of low refraction. An advantage of the finger only contacting the semiconductor at a number of specific contacts areas is that electron-hole recombination of photo-induced charge carriers at the metal-semiconductor interface will be reduced.

In one embodiment the cross-section of the low refractive index areas and/or high refractive index areas are smaller than 300 nm. In another embodiment the dimensions of high refractive index areas and/or low refractive index areas are varied along a finger. Varying the cross-sectional dimensions the refractive material areas and the metal fingers allows simple control of design of the transparent areas and the scattering areas for optimizing the coupling of light from the solar spectrum into the semiconductor layer.

In a further embodiment the fingers are buried or partly buried in the thin-film semiconductor. This will shift the surface plasmon resonance to the infra-red, i.e. below the bandgap of the solar cell thereby increasing the transparency of the metal fingers for wavelengths in the visible solar spectrum for both polarization directions.

In one embodiment the thin-film semiconductor layer, which may be deposited semiconductor layer or a thin or thinned semiconductor wafer, has a thickness between 1 and 100 µm, preferably between 2 and 50 µm. In another embodiment a first predetermined number of fingers are longitudinally arranged next to each, the distance between two neighboring fingers being between 0,3 and 10 µm, preferably between 0,6 and 5 µm. The nano-sized metal contact fingers allow a finer metallization pattern when compared to conventional contact structures. Hence, the photo-generated charge carriers can be transported out of the semiconductor layer without the need for a highly doped surface emitter layer, which would degrade the blue-response of the solar cell. A metallization pattern comprising nanosized fingers with micron-sized inter-finger spacing also allows for efficient transport of photo-generated charge carriers out of low quality semiconductor layers.

In one embodiment the fingers are in contact with a locally doped region of a second conductivity type disposed in the semiconductor layer, the doped region being substantially located underneath and in contact with the fingers of the contact structure. In a further embodiment the doped region and the fingers comprises a group III metal, preferably aluminum. Using metal fingers comprising a group III metal allows the formation of self-aligned p-n junction providing a Ohmic contact with the contact finger thus providing further improvement in efficiently transporting the photo-induced charge carriers out of the semiconductor.

In a further embodiment a plurality of metal nano-structures, the metal preferably selected from the group of Au, Ag, Cu or Al, are arranged over the semiconductor layer and between the fingers, the cross-section of each nano-structure being smaller than 300 nm.

In one embodiment the shape of each nano-structure is substantially anisotropical and/or the shape of the nanoparticles has a relatively large contact area for resonantly coupling with the underling semiconductor layer. In a further embodiment the shape of the nano-structures is substantially hemispherical, cylindrical or hemicylindrical. Anisotropically shaped nano-structures such as cylindrically or hemispherically shaped nano-structures allow a large area to be close to the semiconductor layer as such provide very efficient resonant coupling of light.

In one embodiment the diameter of the cylindrical and hemispherical structures may be varied between 100 and 300 nanometer in order efficiently couple different wavelengths of the solar spectrum into the semiconductor layer.

In another aspect the invention relates to a photovoltaic cell, comprising a semiconductor layer, preferably a thin-film semiconductor layer provided on a support substrate, of a first conductivity type; a plurality of surface plasmon resonance nano-structures provided over the semiconductor layer for resonantly coupling light into the semiconductor layer, wherein the dimensions of the cross-section of each nano-structure is smaller than 300 nm, and wherein the shape of each nano-structure is substantially anisotropical and has a relatively large contact area with the underling layer.

The use of nanostructures eliminates the need for measures to increase the effective surface area of a thin-film photovoltaic cell as used in conventional solar cell fabrication techniques such texturing the surface of the semiconductor. Hence, the use of anisotropically shaped nano-structures metal nano-structures with a large contact area allows simple fabrication of high efficient planar (i.e. non-textured) solar cells. In one embodiment the shape of the nano-structures is substantially hemispherical, cylindrical or hemicylindrical. In a further embodiment the nano-structures may also be provided between the back of the semiconductor layer and the back contact thereby further increasing the efficiency of the cell.

In a further aspect the invention relates to a method of fabricating a plasmon resonance generating metallic contact on a photovoltaic cell. The method comprises the steps of: providing a semiconductor layer, preferably a thin-film semiconductor layer on a support substrate, of a first conductivity type; depositing a metal surface plasmon resonance generating contact structure for resonantly coupling light into the semiconductor layer and transporting photo-induced charge carriers out of the semiconductor layer, the contact structure comprising a plurality of metal fingers in electrical contact with the semiconductor layer, the dimensions of the cross-section of each finger being smaller than 300 nm.

In one embodiment the deposition step comprises the steps of: providing a curable resin on the front side of the semiconductor layer; transferring a pattern of an imprint template into the resin, the pattern of the imprint template corresponding to the pattern of the a predetermined plasmon resonance generating contact structure comprising a plurality of fingers, the dimensions of the cross-section of each finger being smaller than 300 nanometer; etching the imprinted resin pattern in order to expose the surface of the semiconductor layer; depositing a metal layer over the imprinted resin pattern; removing the resin from the semiconductor layer. Using an imprint technique allows simple fabrication of large area nano-structured surface plasmon generating contact metallizations.

In one embodiment the pattern of the imprint template further comprises a plurality of protrusions, the protrusions corresponding to a plurality of anisotropically shaped nano-structures having a large contact area to be formed on the semiconducting layer between the strips of the top contact structure, the cross-section of each nano-structure being smaller than 300 nanometer.

In one embodiment the metal layer comprises a group III metal, preferably aluminum, and wherein the method further comprising the step of forming a locally doped region underneath the metallic top contact by annealing the semiconductor layer around or above the eutectic temperature of the group III metal.

In a further embodiment the method further comprises the steps of depositing a thin metal film, preferably Ag, over the semiconductor layer comprising the metallic top contact and annealing the thin metal film using a temperature between 150 to 400 degree Celsius in order to allow the thin metal film to coalesce to form random distributed metallic nano-sized particles.

In yet a further aspect the invention relates to a method of fabricating a plurality of surface plasmon resonance nano-structures over a semiconductor layer of a photovoltaic cell. The method comprises the steps of: providing a semiconductor layer, preferably a thin-film semiconductor layer on a support substrate, of a first conductivity type; and depositing a plurality of surface plasmon resonance nano-structures provided over the semiconductor layer for resonantly coupling light into the semiconductor layer, wherein the dimensions of the cross-section of each nano-structure is smaller than 300 nm, and wherein the shape of each nano-structure is substantially anisotropical and has a relatively large contact area with the underling layer.

In one embodiment the deposition step comprises the steps of: providing a curable resin on the front side of the semiconductor layer; transferring a pattern of an imprint template into the resin, the pattern of the imprint template comprises a plurality of protrusions corresponding to a plurality of anisotropically shaped nano-structures having a large contact area, the cross-section of each protrusion being smaller than 300 nanometer; depositing a metal layer over the imprinted resin pattern; removing the resin from the semiconductor layer.

The invention will be further illustrated with reference to the attached drawing, which schematically show embodiments according to the invention. It will be understood that the invention is not in any way restricted to these specific embodiments.

### Brief description of the drawings

Fig. 1 depicts a schematic of a contact structure comprising metal contact fingers having nanoscale dimensions.
Fig. 2 depicts a schematic of p-n junctions formed directly underneath the contact fingers.
Fig. 3 depicts exemplary embodiments of photovoltaic structures having partially buried contact fingers.
Fig. 4 illustrates the fraction of light scattered into a silicon substrate for various shaped nano-structures.
Fig. 5 depicts a contact structure having nanoscale structures provided between the metal contact fingers.
Fig. 6 depicts one embodiment of a contact structure wherein the refraction index along the surface of a metal finger is locally varied.
Fig. 7 depicts another embodiment of a contact structure wherein the refraction index along the surface of a metal finger is locally varied.

### Detailed description

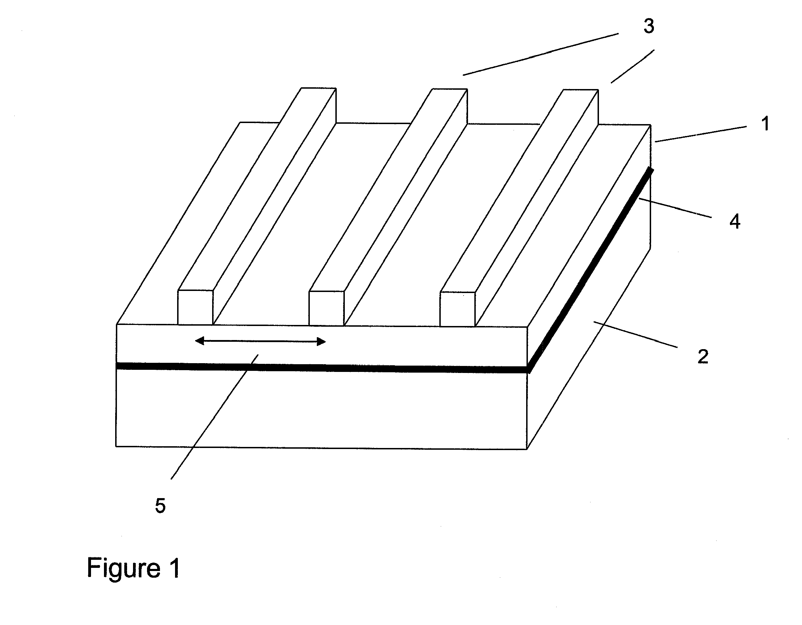

Fig. 1 illustrates a schematic of a solar cell with the contact structure according to one embodiment of the invention. A thin-film semiconductor absorber layer 1, having a thickness between 1-100 µm, preferably between 2-50 µm, is provided over a support substrate 2. The semiconductor layer may be semiconductor deposited on a support substrate or a thin semiconductor wafer attached, e.g. by bonding or gluing, to a support substrate. The semiconductor layer may be an amorphous or a (poly)crystalline semiconductor. The semiconductor may be selected from the group consisting of silicon, GaAs and related III-V compounds, CdTe, Cu(In,Ga)(Se,S) CdSe, PbS, PbSe, engineered materials e.g. a silicon quantum dot superlattice or any other semiconductor material suitable for use in a photovoltaic cell.

A number of metal fingers 3 are arranged next to each other over the top surface of and in contact with the semiconductor layer. Optionally, a thin interlayer of a transparent conducting oxide, e.g. zinc oxide or tin oxide, may be provided between the metal contact fingers and the semiconductor layer in order to adjust the dielectric environment of the fingers, while still allowing conduction between the fingers and the semiconductor layer. The contact fingers extend over a substantial part of the top area of the semiconductor layer and may be electrically connected to each other be one or more metallic busbars (not shown). The bottom side of the semiconductor layer is in contact with a rear electrode 4 having an contact to the outside.

The dimension of the cross-section of the fingers are smaller than 300 nm, i.e. the lower edge of the solar spectrum which ranges approximately from wavelength of 300 nm to 1800 nm. Preferably, the dimensions of the cross-section are between approximately 100 and 200 nanometers. The reduced dimension of the fingers results in a increase in resistance, however such increase is compensated by the decreased spacing between the fingers and can be further compensated by using thicker metals. Metals which exhibit low absorption losses are preferably used in the formation of the metal fingers. In one embodiment the metal fingers comprise a metal selected from the one of Au, Ag, Cu or Al.

For light polarized perpendicular to the longitudinal axis of the finger, the finger constitutes a metal surface plasmon resonant scatter, effectively scattering the light into the underlying semiconductor layer. For light polarized parallel to the longitudinal axis of the finger, the light will be absorbed in the metal. Hence, the surface plasmon resonance generating contact structure comprising nanoscale fingers approximately leads to half the loss of their marcroscopic counterparts covering the same fraction of the substrate.

The inter-finger spacing 5, i.e. the distance between two neighboring fingers, is between 1 to 100 µm, preferably between 2 and 10 µm. Since the fingers are effectively transparent for light polarized perpendicular to the longitudinal axis of the finger, and the fingers are much narrower than the fingers of conventional screen-printed solar cells, the inter-finger spacing can be made much smaller than that of conventional screen-printed solar cells. Hence, the photo-generated charge carriers can be transported out of the semiconductor layer without the need for a highly doped surface emitter layer, which would degrade the blue-response of the solar cell.

The plasmon resonance generating metal contacts comprising nano-sized metal contact fingers and the plasmon resonance generating nano-structures for use in a photovoltaic cell may be fabricated using various known lithography techniques such as UV, X-ray, e-beam lithography and other related techniques. Alternatively, an adapted screen-print or inkjet printing technique may be used which allowing direct printing of nano-sized metal structures (see e.g. Zhao et al., "Self-aligned inkjet printing of highly conducting gold electrodes with submicron resolution", Journal of Applied Physics 101, 064513, 2007).

One particular useful technique for large area application is the imprint lithography technique. This technique is described in US patent application US2008/0011934, which is hereby incorporated by reference into this application. Using this method an imprint template corresponding to the pattern of a predetermined plasmon resonance generating contact structure with typical dimensions as described in relation with Fig. 1 is made. The structure of the imprint template is transferred to a curable resin layer which is disposed over the semiconductor layer of the photovoltaic cell. After curing the resin the patterned resist layer is etched in order to expose the surface of the semiconductor layer. Deposition of a metal layer over the imprinted resist pattern, followed by a lift-off finalizes the realization of the contact structure.

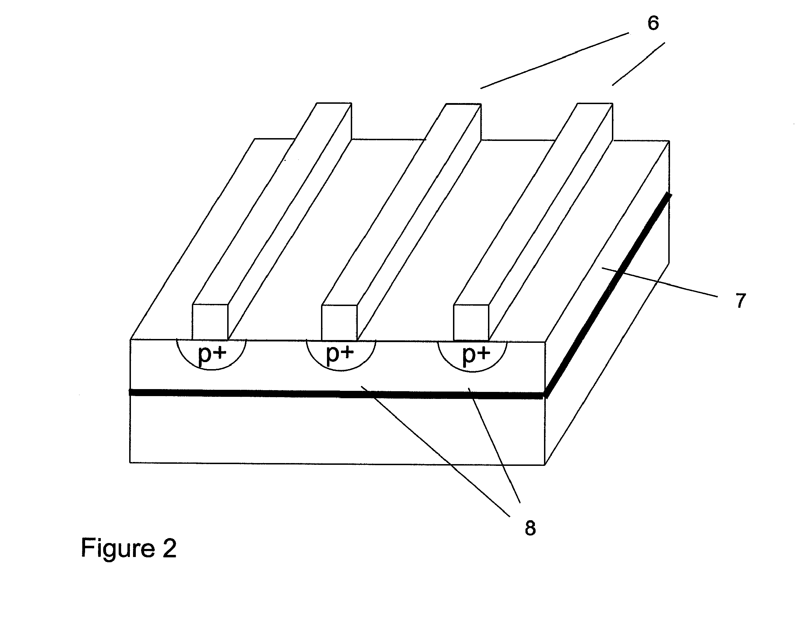

In a further embodiment a locally doped region underneath the metal finger may be formed. This embodiment is depicted in Fig. 2. Metal fingers 6 comprising a group III metal, preferably aluminum, are formed on a n-type doped silicon layer 7. By increasing the temperature above the eutectic temperature of the group III metal, e.g. approx. 500 degrees Celsius for aluminum, a self-aligned p-n junction 8 is formed directly underneath the area where the metal finger is in contact with the semiconductor. The heating step may be provided by e.g. a rapid thermal annealing step or laser annealing technique. The p-type region provides an Ohmic contact with the aluminum contact finger thus providing further improvement in efficiently transporting the photo-induced charge carriers out of the semiconductor.

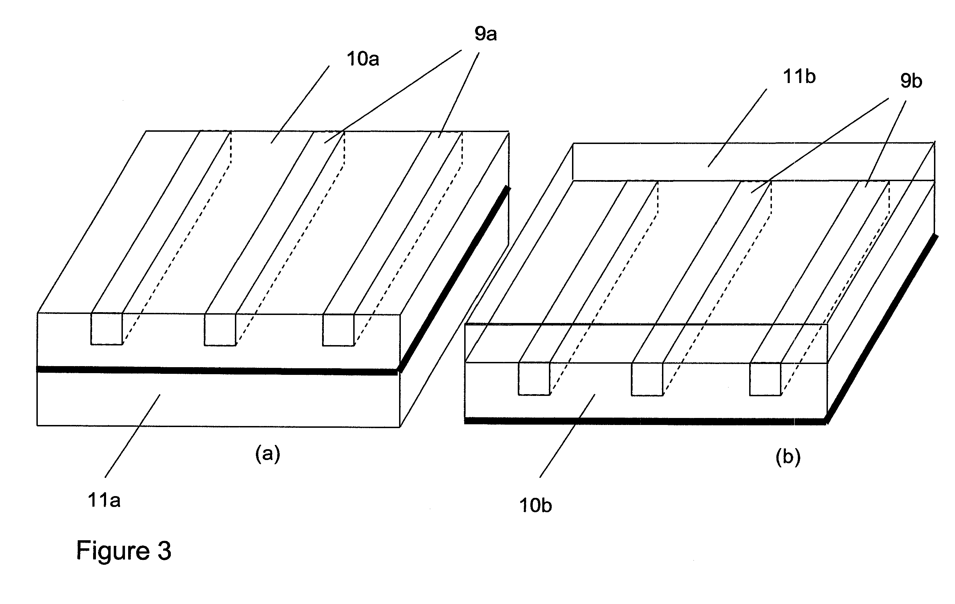

Fig. 3. (a) and (b) depict two alternative embodiments wherein the metal fingers are partially buried in the semiconductor layer. The metal fingers 9a,9b are located in a number of longitudinal trenches formed in the semiconductor layer 10a, 10b. These trenches may be fabricated using the same imprint technology described in relation with Fig. 1. The top surface of the metal fingers may be made at approximately the same level as the top surface of the semiconductor layer thereby allowing simple contacting of the metallic fingers. Partly burying the metal fingers will increase the contact surface of the metal fingers with the semiconductor material of the absorber layer. The semiconductor material is a high refractive index material and thus will cause the surface plasmon resonance to shift to the infra-red, i.e. below the bandgap of the solar cell. This will increase the transparency of the metal fingers for wavelengths in the visible solar spectrum for both polarization directions.

Fig. 3(b) depicts a cell having buried contact electrodes which are fabricated on a transparent support substrate 11b. Such substrate may be made of glass or a plastic. In this embodiment the metal contact structure is deposited on the glass substrate using for example a nano-imprint technology as described in relation with Fig. 1. Over the metal contact structure the thin-film semiconductor is deposited thereby providing a buried contact structure.

In a further embodiment the metal fingers are completely covered by a semiconducting layer. The surface plasmon resonace of this embodiment is even further shifted into the infra-red spectrum further, thus further increasing the transparency of the contact structure and reducing the losses due to absorption of visible light having a polarization in the direction parallel to the finger. Reducing the optical losses in this way allows the parameters of the contact structure to be determined from the optimization of the electrical characteristics of the contact structure only, thereby both increasing the performance of the photovoltaic cell and simplifying the rules for solar cell design.

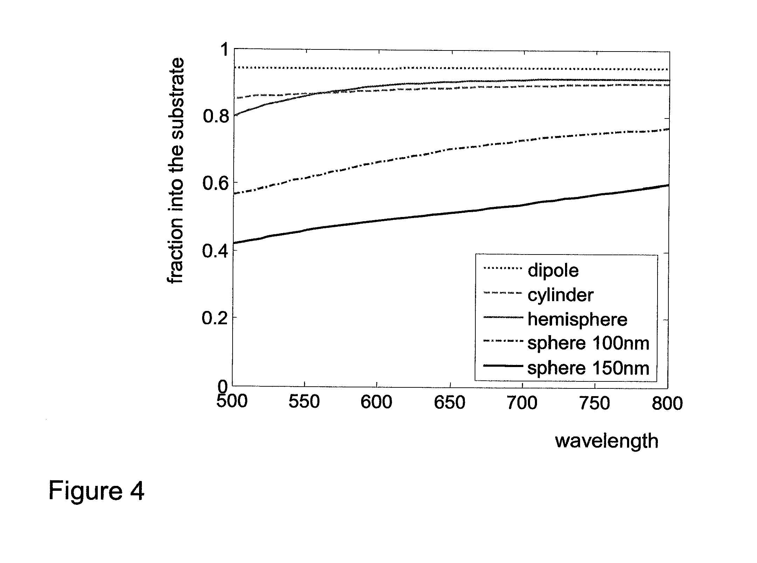

The shape of the cross-section of the finger greatly influences the resonant behavior of surface plasmon excitations in the fingers. The effect of the shape is depicted in more detail in Fig. 4, which shows the fraction of light scattered into a silicon substrate as a function of the wavelength for different shapes of silver nano-structures covering the surface of the substrate. Fig. 4 indicates that nano-structures in the form of a cylinder (having a diameter of 100 nm and a height of 50 nm) and a hemisphere (having a diameter of 100 nm) come close to the performance of an ideal dipole scatter. Nano-spheres (having a diameter of 100 nm and 150 nm respectively) scatter much less light into the semiconductor substrate.

From Fig. 4 it can be derived that nano-structures having a strong shape-anisotropy and nano-structures having a relatively large contact area with the underling thin-film semiconductor layer exhibit enhanced surface plasmon resonant behavior. Hence, in one embodiment the fingers are shaped to have a relatively large contact area providing good optical coupling with the underlying semiconductor in combination with a strong shape-anisotropy. One preferential embodiment comprises one or more metal fingers which are substantially hemi-cylindrically shaped.

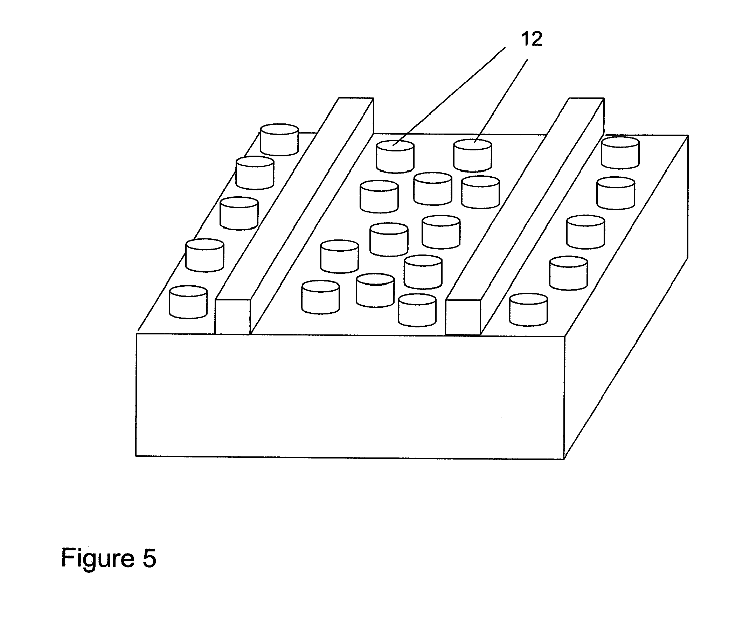

In a further embodiment nanoscale structures of various shapes may be provided between the metal fingers. Fig. 5 illustrates an exemplary embodiment of such contact structure comprising cylindrically-shaped nano-structures 12 disposed between the fingers. The nano-structures which may be arranged in a random, periodic or quasi-periodic arrangement between the fingers, provide further surface plasmon resonant scatters for coupling light into the semiconductor. A thin interlayer for surface passivation (e.g. thin-film silicon dioxide, silicon nitride, amorphous silicon layer) having a thickness in range 1-50 nm, preferably 2-20 nm. Materials may be provided between the nano-structure and the semiconductor layer. The dielectric will shift the plasmon resonance frequency. This effect allows tuning of resonance frequency.

The coupling between the nano-structure and the semiconductor layer occurs partly through modes with a in-plan wavevector that are evanescent in air and - when applicable - in the interlayer for passivating the surface of the semiconductor or tuning the plasmon resonance. This rapid decay with increasing distance from the substrate, hence the distance and the shape of the nano-structure are important parameters for efficient coupling. Hence, nano-structures which allow a large area to be close to the semiconductor layer such as e.g. cylindrically or hemispherically shaped nano-structures provide very efficient resonant coupling of light.

In a further embodiment nano-structures may also be provided between the back of the semiconductor layer and the back contact thereby further increasing the efficiency of the cell.

The use of nanostructures eliminates the need for measures to increase the effective surface area of the cell as used in conventional solar cell fabrication techniques, e.g. by using a textured surface. Increasing the surface area by texturing the semiconducting absorber results in increased surface recombination losses thus degrading the overall solar cell performance. Hence, the use of metal nano-structures in combination with the metal contact fingers of the present invention allows simple fabrication of high efficient planar (i.e. non-textured) solar cells.

Similar to the shape of the contact fingers as described in relation with Fig. 4, preferential shapes of the nano-structures should provide a relatively large contact area in combination with a strong shape-anisotropy. Such preferential shapes include cylindrical, hemispherical or hemicylindrical shaped structures. The diameter of the (hemi)cylindrical and hemispherical structures may be varied between 100 and 300 nanometer in order efficiently couple different wavelengths of the solar spectrum into the semiconductor layer.

In another embodiment nano-structures may be combined with partially buried contact fingers as described in relation to Fig. 3. In this embodiment the nano-structures may be directly formed onto the surface of the semiconductor comprising the partial buried fingers. The dimensions and the shape of the metal fingers and particles may be chosen that the plasmon resonance of the metal fingers would be below the bandgap of the semiconductor, and hence would be transparent to the wavelength of interests, while the plasmon resonance of the nano-structures would be at the bandgap of the semiconductors, and hence provide effective light-trapping for weakly absorbed light.

The nanostructures may be fabricated using lithographic techniques, nano-imprinting techniques and the techniques as described in relation with Fig. 1, allowing precise control of the shape of the nano-particles which is needed when fabricating e.g. cylindrical or hemispherical structures. Variation of the evaporation conditions may change the shape from cylindrical to hemispherical-shaped structures. These techniques also allow the fabrication of the contact fingers and the nanostructures in one fabrication step.

In the case of an imprint technique the pattern of the imprint template comprises a plurality of protrusions which correspond to a plurality of preferentially shaped nano-structures to be formed on the semiconductor layer between the strips of the top contact structure. The cross-section of these protrusions is smaller than 300 nanometer.

Alternatively, the nano-structures can be fabricated by evaporation of a thin-film metal layer of approximately 10-30 nm and subsequent annealing as described in Pillai et al. This technique allows a simple way of forming random arrangements of spherical or ellipsoid-shaped particles on the top area of the semiconductor. Such particles may also be formed using chemical or electrochemical deposition.

The contact area of the nanostructures may be varied by changing the wetting properties of the underlying layer, e.g. by varying its roughness or surface chemistry, before depositing the metal. An annealing step may allow the particles to take a more optimized shape.

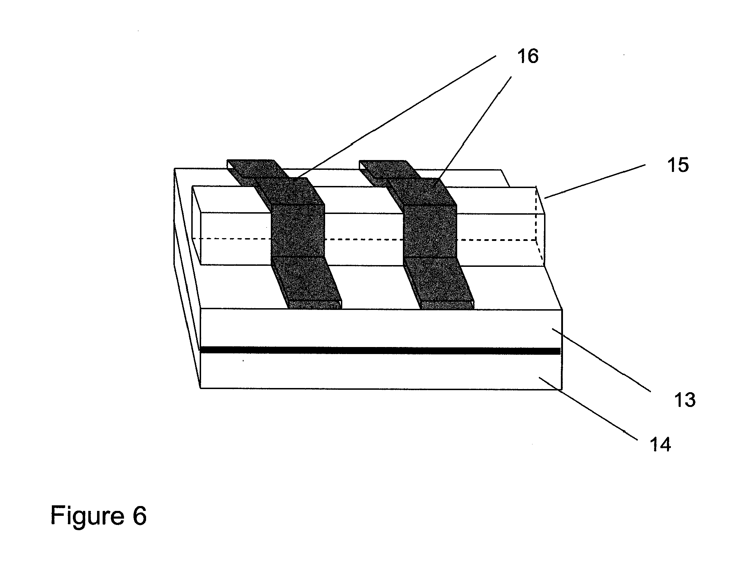

Fig. 6 depicts a schematic of a metal contact finger for a photovoltaic cell according to yet another embodiment of the invention. A thin-film semiconductor layer 13 is formed on a support substrate 14. A metal finger 15 is provided over and in contact with the thin-film semiconductor. At a number of locations 16 along the finger the metal is covered or partly covered with a high refractive index material such as a semiconductor, e.g. amorphous silicon or GaP. Other high refractive index materials include metal oxides like Ta2O5, Ti305, TiO2, ZrO2, Nb205, CeO2 and silicon nitride. The locations may be formed by depositing a number of thin-film lines of high refractive material over the metal fingers, wherein the longitudinal axis of the high refractive material lines are arranged perpendicular the longitudinal axis of the metal fingers.

The high refractive index material lines may be fabricated using the lithograpc and/or printing techniques as described in relation with Fig. 1. In one embodiment, a thin layer of insulating resin (e.g. a SiO2 or TiO2 based sol-gel) may be imprinted in a stripe pattern. In yet a further embodiment, the high refractive index material lines are formed over a contact structure having partly buried metal contact fingers as described in relation with Fig. 3.

The portions along the surface of the metallic finger covered by the high refractive index material define areas having an index of high refraction. These areas are separated by areas having an index of low refraction, i.e. areas which are not covered with the high refractive index material or covered with a low refractive index materials such as SiO2. At the areas having an index of high refraction the surface plasmon resonance for both polarization directions (i.e. perpendicular and parallel to the longitudinal axis of the finger) are shifted to the infra-red, i.e. below the bandgap of the semiconductor layer.

Hence, along its longitudinal axis the electrical continuous metal finger is divided in (i) areas having an index of high refraction which are almost completely transparent for wavelengths of interests (i.e. the solar spectrum) and (ii) areas having an index of low refraction which effectively form surface plasmon resonant scatters for wavelengths of the solar spectrum. The presence of areas having an index of high refraction thus avoids or reduces the problem of absorption of light that is polarized parallel to the axis of the finger.

In one embodiment the contact structure comprises a number of parallel aligned electrical continuous metal fingers and a number of lines of a high refractive material formed over the fingers, wherein the longitudinal axis of the lines is perpendicular to the longitudinal axis of the fingers. This contact structure effectively forms an artificial lattice of surface plasmon resonant scatters allowing both effective coupling of light into the thin-film semiconductor layer and transport of photo-induced charge carriers out of the semiconductor layer. In addition, the lines of high refractive materials formed over the fingers also provides the advantage of providing light trapping by diffraction of the light from the high refractive index material into the semiconductor (instead or in conjunction with the metal nano-structures).

Varying the cross-sectional dimensions of the lines of high refractive materials, the metal fingers and distance between these lines and fingers respectively allows simple control of design of the transparent areas and the scattering areas. Preferably, the dimension of the scattering areas is smaller than 300 nanometers.

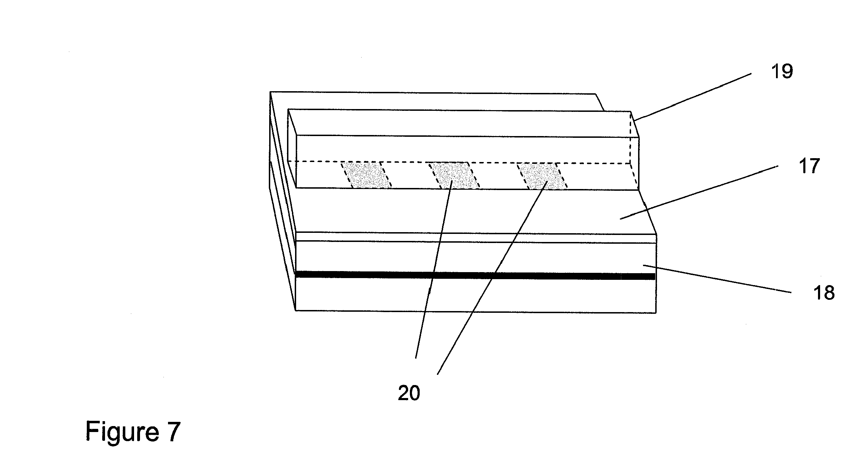

Fig. 7 depicts a schematic of another embodiment of a contact structure wherein the refraction index along the surface of one or more metal fingers is locally varied. In this embodiment a low refractive index isolation layer 17, e.g. a SiO2 thin-film layer, is provided over the semiconductor layer 18. The metal finger 19 is located over the isolation layer and over a predetermined number of contact holes 20 in the isolation layer. At the contact holes the metallic finger makes electrical contact with the semiconductor layer. In this configuration the areas of the metal finger in contact with the semiconductor layer form areas having an index of high refraction and the areas of the metallic finger in contact with the passivation layer form areas having an index of low refraction. An advantage of the finger only contacting the semiconductor at a number of specific contacts areas is that electron-hole recombination of photo-induced charge carriers at the metal-semiconductor interface will be reduced.

The invention is not limited to the embodiments described above, which may be varied within the scope of the accompanying claims.

## Claims

1. Photovoltaic cell, comprising
a semiconductor layer, preferably a thin-film semiconductor layer on a support substrate, of a first conductivity type provided;
a surface plasmon resonance generating contact structure provided on the semiconductor layer for resonantly coupling light into the semiconductor layer and transporting photo-induced charge carriers out of the semiconductor layer,
wherein the contact structure comprises a plurality of metal fingers in electrical contact with the semiconductor layer, the dimensions of the cross-section of each finger being smaller than 300 nm.

2. Photovoltaic cell according to claim 1, wherein the dimensions of the cross-section of each finger are within a range between 100 to 200 nanometer.

3. Photovoltaic cell according to claims 1 or 2, wherein the dielectric environment of the fingers is varied along its length by alternately contacting the finger locally with a high refractive index material and a low refractive index material.

4. Photovoltaic cell according to claim 3, wherein each finger makes contact with the thin-film semiconductor through a number of contact windows in a low refractive index isolation layer provided over the thin-film semiconductor layer or wherein a predetermined number of areas of each finger is covered with a high refractive index material.

5. Photovoltaic cell according to any of claims 1 to 4, wherein one or more fingers are buried or partly buried in the thin-film semiconductor.

6. Photovoltaic cell according to any of claims 1 to 5, wherein the thin-film semiconductor layer has a thickness between 1 and 100 µm, preferably between 2 and 50 µm and/or wherein the fingers are longitudinally arranged next to each, the distance between two neighboring fingers being between 0,3 and 10 µm, preferably between 0,6 and 5 µm.

7. Photovoltaic cell according to any of claims 1 to 6, wherein the fingers are in contact with a locally doped region of a second conductivity type disposed in the semiconductor layer, the doped region being substantially located underneath and in contact with the fingers of the contact structure.

8. Photovoltaic cell according to any of claims 1 to 7, wherein a plurality of metal nano-structures, the metal preferably selected from the group of Au, Ag, Cu or Al, are arranged over the semiconductor layer and between the fingers, the cross-section of each nano-structure being smaller than 300 nm.

9. Photovoltaic cell according to claim 8, wherein the shape of each nano-structure is substantially anisotropical and wherein the shape of the nanoparticles has a relatively large contact area for resonantly coupling with the underling semiconductor layer.

10. Photovoltaic cell, comprising:
a semiconductor layer, preferably a thin-film semiconductor layer provided on a support substrate, of a first conductivity type;
a plurality of surface plasmon resonance nano-structures provided over the semiconductor layer for resonantly coupling light into the semiconductor layer,
wherein the dimensions of the cross-section of each nano-structure is smaller than 300 nm, and
wherein the shape of each nano-structure is substantially anisotropical and has a relatively large contact area with the underling layer.

11. Photovoltaic cell according to claim 10, wherein the shape of the nano-structures is substantially hemispherical, cylindrical or hemicylindrical.

12. Method of fabricating a plasmon resonance generating metallic contact on a photovoltaic cell, comprising the steps of:
providing a semiconductor layer, preferably a thin-film layer on a support substrate, of a first conductivity type;
depositing a metal surface plasmon resonance generating contact structure for resonantly coupling light into the semiconductor layer and transporting photo-induced charge carriers out of the semiconductor layer onto the semiconductor layer, the contact structure comprising a plurality of metal fingers in electrical contact with the semiconductor layer, the dimensions of the cross-section of each finger being smaller than 300 nm.

13. Method according to claim 12, wherein the deposition step comprises the steps of:
providing a curable resin on the front side of the semiconductor layer;
transferring a pattern of an imprint template into the resin, the pattern of the imprint template corresponding to the pattern of the a predetermined plasmon resonance generating contact structure comprising a plurality of fingers, the dimensions of the cross-section of each finger being smaller than 300 nanometer;
etching the imprinted resin pattern in order to expose the surface of the semiconductor layer;
depositing a metal layer over the imprinted resin pattern;
removing the resin from the semiconductor layer.

14. Method according to 13, wherein the pattern of the imprint template further comprises a plurality of protrusions, the protrusions corresponding to a plurality of anisotropically shaped nano-structures having a large contact area to be formed on the semiconducting layer between the strips of the top contact structure, the cross-section of each nano-structure being smaller than 300 nanometer.

15. Method according to claim 12, wherein the metal layer comprises a group III metal, preferably aluminum, and wherein the method further comprising the step of forming a locally doped region underneath the metallic top contact by annealing the semiconductor layer around or above the eutectic temperature of the group III metal.

16. Method according to claim 12, the method further comprising the steps of depositing a thin metal film, preferably Ag, over the semiconductor layer comprising the metallic top contact and annealing the thin metal film using a temperature between 150 to 400 degree Celsius in order to allow the thin metal film to coalesce to form random distributed metallic nano-sized particles.
